# EUROPEAN PATENT APPLICATION

(11) **EP 0 863 228 A1**
(43) Date of publication of application: **09.09.1998**
(21) Application number: 98301346.7
(22) Date of filing: 24.02.1998
(51) Int. Cl.: C23C 16/44

(54) **Vertical type CVD apparatus**

(30) Priority: 25.02.1997 JP 40923/97
(71) Applicant: SHIN-ETSU HANDOTAI COMPANY LIMITED, Chiyoda-ku Tokyo (JP)
(72) Inventor: Serizawa, Yoichi, Nishishirakawa-gun, Fukushima-ken (JP)
(74) Representative: Cooper, John

(57) **Abstract**

A vertical type CVD apparatus (1) is provided in which an inner tube (2, 10) is mounted or demounted with ease. The vertical type CVD apparatus (1) comprises inner and outer tubes (2, 10; 3) constituting a double structure, wherein the inner tube (2, 10) can be divided into a plurality of parts along an upward or downward direction and adjacent parts thereof are respectively made of materials mutually different in thermal expansion coefficient.

## Description

### BACKGROUND OF THE INVENTION

### Field of the Invention

The present invention relates to a CVD (Chemical Vapor Deposition) apparatus and more particularly, to an inner tube structure of a vertical type CVD apparatus.

### Related Art

There is available a vertical type CVD apparatus as one of CVD apparatuses. The vertical type CVD apparatus comprises: inner and outer tubes constituting a double structure; and a heater surrounding the outer tube, as shown in Publication of Unexamined Japanese Patent Application No. Hei 5-190468 for example. Lower open ends of the inner and outer tubes are covered by a cap and a reaction chamber is formed in a region partitioned by the inner tube and the cap. A turn table is provided in the reaction chamber and a susceptor is placed on the turn table. The susceptor supports a plurality of wafers. The interior and exterior of the inner tube are communicated with each other by a opening formed in the inner tube.

In the vertical type CVD apparatus, after many wafers are placed on the susceptor in the reaction chamber, a source gas is fed from a plurality of gas supply pipes which open in the reaction chamber and a reaction is conducted, so that a desired CVD thin film is formed on the wafers. An excessive gas is exhausted from a gas exhaust port.

In forming a CVD thin film on a wafer, the CVD thin film is deposited on both side surfaces, inner and outer, of the inner tube. Especially, if the CVD film is a silicon CVD thin film including an impurity, the following problems occur:

That is, in the case where a silicon single crystal thin film is formed on a wafer, an impurity attached to the inner tube evaporates into a reaction chamber and then incorporated in a silicon single crystal thin film on the wafer, so that there arises a problem that an impurity concentration profile in the silicon single crystal thin film is wrongly affected.

For this reason, in a vertical type CVD apparatus having an inner tube, the inner tube is often taken out and cleaned.

However, in company with a trend of increase in a wafer diameter and required mass production, an inner tube of the CVD apparatus is larger in not only inner and outer diameters but a length thereof and as a result, a weight thereof is also larger. Especially when an inner tube made of a high purity silicon carbide or the like is used, a weight thereof is large. Therefore, mounting and demounting an inner tube has been becoming not easy.

Besides, workability is poor and there is a risk that an inner tube is broken down by an external shock caused when an end of the tube hits a part of an apparatus in mounting or demounting. If an inner tube is made of high purity SiC, which is expensive, or the like, a loss is large.

### SUMMARY OF THE INVENTION

The present invention has been made in light of the above mentioned problems and it is an object of the present invention to provide a vertical type CVD apparatus in which an inner tube can be mounted or demounted with ease.

A first aspect of the present invention is directed to a vertical type CVD apparatus which comprises: inner and outer tubes, wherein the inner tube can be divided into a plurality of parts along an upward or downward direction and adjacent parts thereof are respectively made of different materials in thermal expansion coefficient.

According to the vertical type CVD apparatus, since the inner tube can be divided into a plurality of parts along an upward or downward direction, each part is not so heavy. Therefore, since parts of the inner tube can individually be mounted or demounted, the entire inner tube can be mounted or demounted with ease. In this case, since adjacent parts thereof are respectively made of materials respectively having mutually different thermal expansion coefficients, a CVD thin film, which is attached on the inner or outer surface of the inner tube, is torn at a boundary between adjacent parts when the inner tube is cooled down to room temperature, so that there arises no problem that adjacent parts thereof are bonded and thereby the respective parts can individually be demounted with ease.

Besides, since an inner tube can be divided into a plurality of parts along an upward or downward direction, even if a part should be broken down, a damage of the breakdown could be suppressed to a minimum.

A second aspect of the present invention is directed to a vertical type CVD apparatus recited in the first aspect, wherein one of adjacent parts is made of SiC and the other is made of transparent quartz glass. SiC is stable in not only a physical sense but a chemical sense, and has a high strength at elevated temperature and high thermal conductivity, and a thermal expansion coefficient as low as 4 x 10⁻⁶/°C, so that a thermal shock resistance is excellent. On the other hand, transparent quartz has a thermal expansion coefficient in the range of 5.5 to 5.8 x 10⁻⁷/°C and an excellent thermal shock resistance as well.

Therefore, when the inner tube is cooled to room temperature, since a CVD thin film attached on the inner and outer sides is torn at a boundary between parts, there arises no problem that adjacent parts are bonded to each other and thus the inner tube can be demounted with ease. Besides, since SiC and transparent quartz are not sources of contamination, they are a preferable material of an inner tube.

A third aspect of the present invention is directed to a vertical type CVD apparatus recited in the first or second aspect, wherein contacting surfaces of adjacent parts each are inclined downwardly toward the interior. According to the vertical type CVD apparatus, since contacting surfaces of adjacent parts each are inclined downwardly toward the interior, only if an upper part is put on a lower part, positioning of the parts can automatically be achieved without any severe positioning, so that the inner tube has an effect that it can be assembled with ease.

### BRIEF DESCRIPTION OF THE DRAWINGS

FIG. 1 is a view of in a longitudinal section of a first embodiment of a vertical type CVD apparatus according to the present invention.

FIG. 2(a) is a view illustrating an assembled inner tube and FIG. 2(b) is an exploded view illustrating a structure of the inner tube of FIG. 2(a), of the first embodiment of a vertical type CVD apparatus according to the present invention.

FIG. 3 is an exploded view illustrating an inner tube of a second embodiment of a vertical type CVD apparatus according to the present invention.

### DETAILED DESCRIPTION OF THE INVENTION

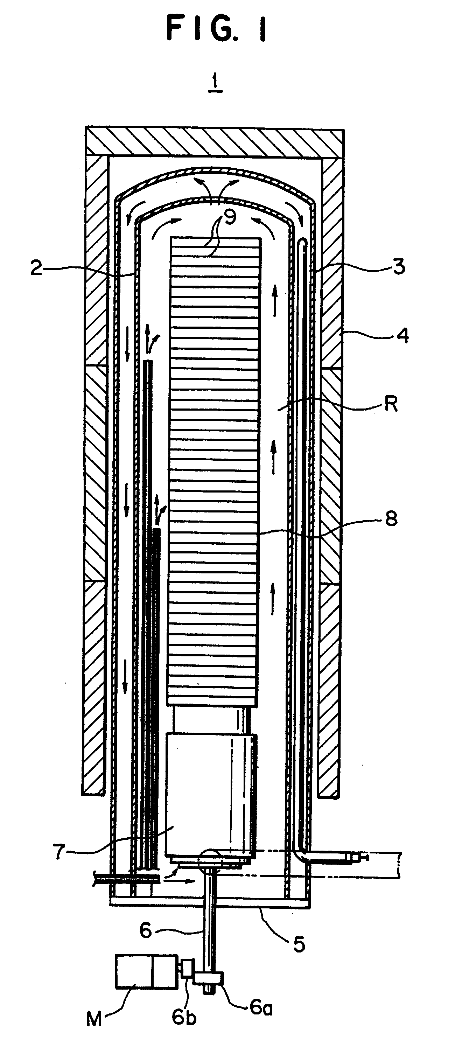

In FIG. 1, there is shown a longitudinal sectional view of a vertical type CVD apparatus. The vertical type CVD apparatus 1 comprises inner and outer tubes 2, 3 constituting a double structure. A heater 4 surrounds the outer tube 3.

Lower ends of the inner and outer tubes 2, 3 are sealed by a cap 5 made of stainless steel. In a reaction chamber R, a support shaft 6 penetrating through the cap 5 along an upward or downward direction is present. The support shaft 6 is connected to a drive motor M with bevel gears 6a, 6b interposing therebetween. A turn table 7 made of, though not limited to, stainless steel is supported on a top end of the support shaft 6. A transparent quartz susceptor 8 is supported on the turn table 7.

The susceptor 8 has many holders 9 arranged in a layered manner at a proper distance between adjacent holders along an upward or downward direction. A plurality of wafers can respectively be set in the holders 9 of the susceptor 8.

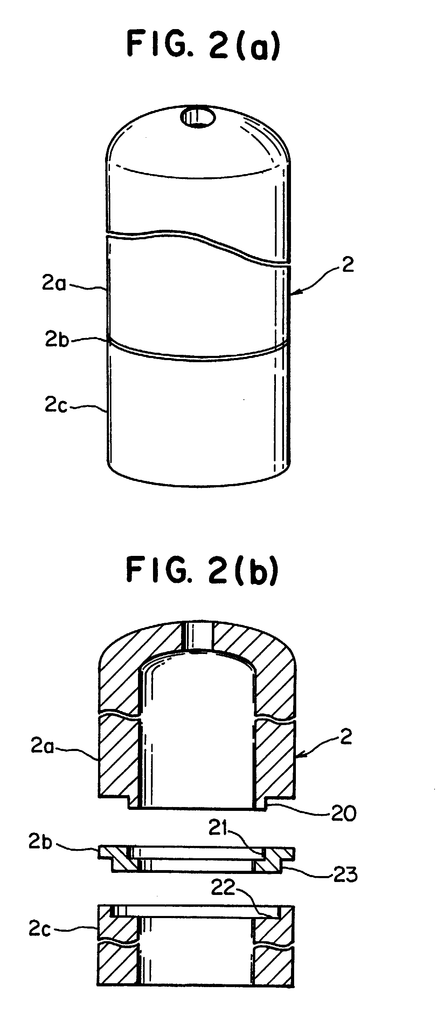

The inner tube 2 of a vertical type CVD apparatus 1 will be described in reference to FIGS. 2(a), (b). The inner tube 2 is constructed globally in a shape like a sheath. The inner tube comprises: a head part 2a, connecting part 2a and base part 2c, wherein in assembling, the head part 2a, connecting part 2b and base part 2c are stacked along a longitudinal direction.

The head part 2a and base part 2c are made of the same material. The connecting part 2b (a ring) connecting the head part 2a with the base part 2c is made of a different material from that of the head part 2a and base part 2c. For example, if the head part 2a and base part 2c are made of transparent quartz, the connecting part is made of SiC. On the contrary, if the head part 2a and base part 2c are made of SiC, the connecting part is made of transparent quartz. Thermal expansion coefficients of SiC (silicon carbide) and transparent quartz are 4 x 10⁻⁶/°C and 5.5 to 5.8 x 10⁻⁷/°C respectively.

The reason why the connecting part 2b interposing between the head part 2a and base part 2c is made of a different material from a material of the head part 2a and base part 2c in thermal expansion coefficient is because cracks are easily produced in CVD thin films deposited on both sides, inner and outer of the inner tube 2 when it is cooled to room temperature. Thereby, the inner tube 2 is not bonded by the CVD film and thus the head part 2a, connecting part 2b and base part 2c are individually taken out with ease in disassembling.

A structure of a contacting portion between the head part 2a and connecting part 2b of the inner tube 2 will be described. An annual step 20 facing downwardly is formed at an inner side of the lower end surface of the head part 2a. An annular step 21 facing upwardly is formed at an outer side of the upper end surface of the connecting part 2b. The annular step 20 and annular step 21 are complementary each of the other to form a perfect cylinder.

In addition, an annular step 22 facing upwardly is formed at an outer side of the upper end surface of the base part 2c of the inner tube 2. An annular step 23 facing downwardly is formed at an inner side of the lower end surface of the connecting part 2c. The annular step 22 and annular step 23 are complementary each of the other to form a perfect cylinder.

According to the vertical type CVD apparatus, since the inner tube 2 is divided into three parts along an upward or downward direction, neither of the parts (the head part 2a, connecting part 2b and base part 2c) is so heavy. Therefore, since each parts of the inner tube can individually be mounted or demounted, the inner tube can be mounted or demounted with ease. In this case, since adjacent parts are respectively made of materials mutually different in thermal expansion coefficient, a CVD thin film deposited on the inner and outer side of the inner tube 2 is torn at a boundary between adjacent parts when the inner tube is cooled to room temperature. Therefore, there arises no problem that adjacent parts are bonded, which makes demounting of the inner tube easy.

Since the inner tube can be divided into a plurality of parts along an upward or downward direction, a loss would be suppressed to a minimum even if one of the parts is broken down.

SiC and transparent quartz are preferable as a material of the inner tube 2 since the materials are not a cause of contamination.

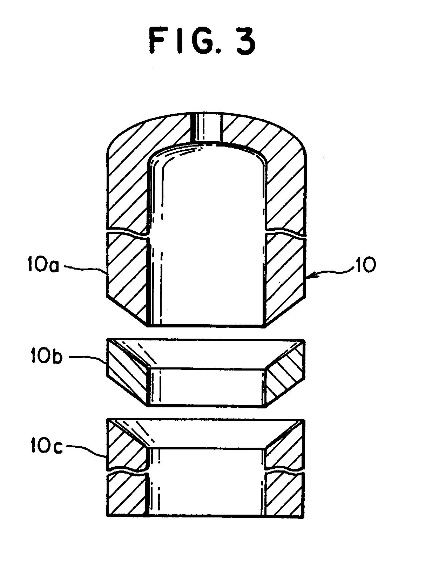

In FIG. 3, an inner tube of the second embodiment used in a CVD apparatus 1 is shown. The inner tube 10 is different from the inner tube 2 of the first embodiment used in a CVD apparatus in the following points, which will be described.

The inner tube 10 according to the second embodiment comprises adjacent parts (head part 10a, connecting part 10b and base part 10c) whose contacting surfaces each are inclined downwardly toward the interior.

In this case, materials of respective parts are selected as are in the first embodiment. The head part 10a and base part 10c are made of the same material. The connecting part 10b connecting the head part 10a with the base part 10c are made of materials mutually different in thermal expansion coefficient from a material of the head part 10a and base part 10c. For example, if the head part 10a and base part 10c are made of transparent quartz, the connecting part is made of SiC. On the other hand, if the head part 10a and base part 10c are made of SiC, the connecting part 10b is made of transparent quartz.

According to the vertical type CVD apparatus 1, since the contacting surfaces of adjacent parts each are inclined downwardly toward the interior of the inner tube, positioning between adjacent parts can automatically set only by putting an upper part on a corresponding lower part without intentional strict positioning and thereby the inner tube has an effect that it is assembled with ease.

While the embodiments of the present invention have above been described, the present invention is not restricted to the descriptions in the embodiments but modifications of and changes in them can still be executed within the scope of the gist of the present invention.

For example, in the aforementioned embodiments, the head parts 2a, 10a and base parts 2c, 10c are made of the same material, but the head parts 2a, 10a, the connecting parts 2b, 10b and the base parts 2c, 10c may respectively be made of materials mutually different in thermal expansion coefficient.

While in the aforementioned embodiments, the inner tubes 2, 10 each can be divided into three parts, the inner tubes 2, 10 each may be divided into more than three parts.

According to the typical embodiments of the present invention, in a vertical type CVD apparatus comprising inner and outer tubes, the inner tubes each can be divided into a plurality of parts along an upward or downward direction and adjacent parts are respectively made of materials mutually different in thermal expansion coefficient, so that each part of each inner tube is not so heavy. Therefore, parts of an inner tube can individually be mounted or demounted and thereby the entire inner tube can very easily be mounted or demounted. In this case, since adjacent parts are respectively made of materials mutually different in thermal coefficient, a CVD thin film deposited on the inner and outer sides in each embodiment is torn when the inner tube is cooled to room temperature and thus there arises no problem that adjacent parts are bonded to each other by the CVD film, which makes demounting of the inner tube easy.

## Claims

1. A vertical type CVD apparatus (1) comprising inner and outer tubes (2, 10; 3) constituting a double structure, characterized by that the inner tube (2, 10) can be divided into a plurality of parts along an upward or downward direction and adjacent parts thereof are respectively made of materials mutually different in thermal expansion coefficient.

2. A vertical type CVD apparatus (1) according to claim 1, wherein one of adjacent parts is made of SiC and the other is made of transparent quartz glass.

3. A vertical type CVD apparatus (1) according to claim 1 or 2, wherein contacting surfaces of adjacent parts each are inclined downwardly toward the interior.
